# EUROPEAN PATENT APPLICATION

(11) **EP 3 608 801 A1**
(43) Date of publication of application: **12.02.2020**
(21) Application number: 17904864.0
(22) Date of filing: 19.05.2017
(51) Int. Cl.: G06F 17/30

(54) **METHOD OF RAPIDLY SEARCHING ELEMENT INFORMATION IN A BIM MODEL**

(30) Priority: 08.04.2017 CN 201710226215
(71) Applicant: Dalian Wanda Group Co., Ltd., Xigang District Dalian Liaoning 116011 (CN)
(72) Inventor: DING, Benxi, Beijing 100022 (CN); QI, Jie, Beijing 100022 (CN); LAI, Jianyan, Beijing 100022 (CN); YIN, Qiang, Beijing 100022 (CN); WANG, Fukui, Beijing 100022 (CN); WANG, Rong, Beijing 100022 (CN); GU, Dongfang, Beijing 100022 (CN); SANG, Guoan, Beijing 100022 (CN); WANG, Yasi, Beijing 100022 (CN)
(74) Representative: Ipside
(86) International application number: PCT/CN2017/085040
(87) International publication number: WO 2018/184283

(57) **Abstract**

A method of rapidly searching element information in a BIM model, at least comprising the following steps: reading a BIM model file, obtaining element information of said BIM model file, and establishing an initial element search rule list; performing category determination on elements in an element list according to a rule in a database, obtaining element type information; determining attributes of elements in the element list according to an attribute definition rule in the database, obtaining element attribute information; optimizing the initial element search rule list according to the obtained element type information and element attribute information; establishing a search order according to weighting of a configured search type and the optimized search rule list, obtaining a comparison screening rule; performing a preliminary search according to the obtained comparison screening rule, obtaining a preliminary search result, and performing optimization processing of the search result; performing filtering of preliminary search results according to a rule configured in the database and obtained element type and attributes, obtaining and caching element search results.

## Description

### FIELD

The present disclosure relates to the field of architectural engineering design, and in particular, to a method for quickly retrieving component information from a BIM model.

### BACKGROUND

A BIM model is very common in the field of architectural engineering design. It is necessary to quickly retrieve and locate a required component, in a case that it is desired to know whether information of the component in the BIM model is complete and whether a geometric position of the component in the BIM model is correct. Virtual model objects, such as a wall and a pipeline, stored in conventional software Revit are abstractly packaged as data. Therefore, it is a hot topic and a difficulty in current development of BIM model software how to retrieve a model required by a user quickly and accurately. A filter API provided by the software Revit is generally used for retrieval in secondary development on the software Revit. Due to lack of customization in rules, there are problems such as low efficiency and low filter fineness in application. Thereby, an algorithm for quick retrieval in component searching is in urgent need for practical application scenarios and application processes of the users.

### SUMMARY

An object of the present disclosure is to provide a method for quickly retrieving component information from a BIM model. The method is capable to address technical problems in conventional technology, and achieve quick retrieval of component information from the BIM model.

Following technical solutions are provided according to embodiments of the present disclosure, so as to address the technical problems.

A method for quickly retrieving component information from a BIM model is provided. The method at least includes:
reading a BIM model file to obtain component information in the BIM model file, and establishing a list of rules for preliminary component retrieval;
determining a category of a component in the component list according to a rule in a database, to obtain category information of the component;
determining an attribute of the component in the component list according to a rule for attribute definition in the database, to obtain attribute information of the component;
optimizing the list of rules for preliminary component retrieval, based on the category information of the component and the attribute information of the component that are obtained;
establishing a retrieval order and obtaining a comparison filter rule, based on a weight of a retrieval type that is set and the optimized list of rules for preliminary component retrieval;
performing preliminary retrieval according to the obtained comparison filter rule, to obtain a preliminary retrieval result, and optimizing the preliminary retrieval result; and
filtering the preliminary retrieval result, according to a rule set in the database and the category and the attribute of the component that are obtained, to obtain a component retrieval result, and storing the component retrieval result.

In one embodiment, the preliminary retrieval is performed by using binary search.

In one embodiment, the method for quickly retrieving component information from a BIM model further includes: filtering a type of virtual data in software Revit, and/or modifying a type of virtual data in software Revit by comparison.

The present disclosure has the following beneficial effects.

The method according to embodiments of the present disclosure is a component retrieval method based on an abstract data type in the software Revit. Through hierarchical and progressive retrieval, a required component is retrieved sequentially, firstly by the BIM model files (model version and trades), secondly by a category of the component (component category determination), and finally by attribute information of the components (component attribute definition). Thereby, a quick retrieval mode is formed, and a component can be quickly retrieved from mass information in a list of a big-project file. Efficiency of such process is improved by reducing a time cost of conventional retrieval from a few minutes to a few seconds, thereby improving efficiency.

### BRIEF DESCRIPTION OF THE DRAWINGS

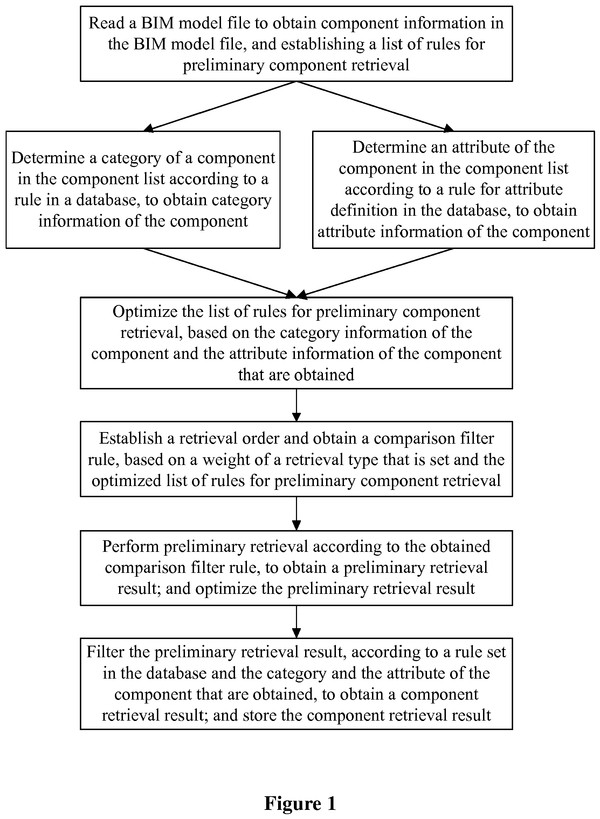

Figure 1 is a flowchart of a method for quickly retrieving component information from a BIM model according to an embodiment of the present disclosure.

### DETAILED DESCRIPTION OF EMBODIMENTS

Hereinafter technical solutions of the present disclosure are further illustrated in conjunction with embodiments and the drawings.

A method for quickly retrieving component information from a BIM model is provided and established so as to retrieve a specific component with a high efficiency. Rereferring to Figure 1, the method according an embodiment of the present disclosure at least includes following steps.

A BIM model file is read to obtain component information in the BIM model file, and a list of rules for preliminary component retrieval is established.

A category of a component in a component list is determined according to a rule in a database, to obtain category information of the component.

An attribute of the component in the component list is determined according to a rule for attribute definition in the database, to obtain attribute information of the component.

The list of rules for preliminary component retrieval is optimized based on the category information of the component and the attribute information of the component that are obtained.

A retrieval order is and a comparison filter rule is obtained, based on a weight of a retrieval type that is set and the optimized list of rules for preliminary component retrieval.

Preliminary retrieval is performed according to the obtained comparison filter rule, to obtain a preliminary retrieval result. The preliminary retrieval result is optimized.

The preliminary retrieval result is filtered according to a rule set in the database and the category and the attribute of the component that are obtained, to obtain a component retrieval result. The component retrieval result is stored.

In one embodiment of the present disclosure, the preliminary retrieval is performed by using binary search.

Hereinafter the method according to an embodiment of the present disclosure is further illustrated in combination with principles of quick data retrieval by using a virtual data model. First, main technical principles and steps in the method of quick data retrieval are described as follows.
1. A list of the virtual data model is acquired to establish a data cache. In this embodiment, the list may be a list of a BIM model file.
2. In a case that a feature to be retrieved can be quantized (for example, the feature itself is in a type of numerical values), a tree structure is established based on the feature. The feature to be retrieved may be the category of the component in the BIM model file, and may be the attribute of the component in the BIM model file.
3. Binary sorting is performed based on the features (namely, a former one and a latter one are exchanged in sequence in a case that the former one is larger than the latter one). Principles of the binary search can be learnt from conventional technology, and is not described in detail herein.
4. Recursive sorting is performed on an overall data structure (namely, the data structures are hierarchically divided into groups for sorting until it is started to compare two pieces of data, and then it is hierarchically returned). That is, the obtained component information is sorted.
5. A new data cache is established by using the sorted data structure, and the old data cache is cleared.
6. The binary search is used to perform quick search in retrieval.
7. When a new feature is used, no new data structure is generated in a case that the new feature can be obtained through conversion from the old feature (for example, A=K×B+C, where A is the new feature, B is the old feature, K denotes a coefficient, and C denotes a constant). The data structure may be directly converted or the retrieval may be directly performed, based on the relationship between the old feature and the new feature.
8. In a case that the feature cannot be quantized, the feature is converted into a Hash value based on a form of the feature. A data structure of a Hash table is established, and the quick retrieval is performed in a manner of index (As an example for English letters, the letters may be converted into a sum of values corresponding to letters, such as letter A corresponding to 1, letter B corresponding to 2, and a value for DAY being 29).

The feature may be determined based on the obtained component information and the rule that is set in the database. A specific process of the determination may be implemented by using the conventional technology and is not described in detail herein.

From the above principles of quick data retrieval, it can be seen that file information and a BIM component of a project are quickly retrieved and located, and categories of the virtual data of the Revit are filtered and modified by comparison in the method according to embodiments of the present disclosure. Steps 1 to 6 are performed in application.
1. An inputted file name (for the BIM model file) is analyzed obtain a list of components that is possible in the file (that is, a domain protocol is recognized according to a naming rule for files, and a category list under a corresponding protocol is applied according to the protocol to reduce repetitive retrieval of entity categories). Redundant possibilities are eliminated, and the list of rules for preliminary retrieval is established.
2. Other possibilities are further eliminated by using a desired retrieval category inputted through a user interface (for example, a range of search may be reduced according to selection of subsidiary check items such as name check/ buildings/ walls/ basic walls). Thereby, the list of rules for retrieval is optimized.
3. According to the retrieval category inputted by the user, a retrieval order is established and a desired comparison filter rule is obtained based on a weight of a retrieval type, such as a domain, whether belong to a system family or not, a category, and a family name.
4. Filtering selection may be performed in a multiplayer nested manner, since a data structure in the Revit is a black box data structure, and a retrieval method with relatively high efficiency and various types of filters (for quick filter and retrieval based on Type and BuiltIn Category of components) are provided. Data of various types are retrieved by combining LINQ technology of C# language, which is a grammar similar to SQL, thereby improving efficiency in component retrieval.
5. The data cache is established after the preliminary retrieval result provided by an API of the Revit is obtained. The data structure such as a key-value pair is established based on a property of data. Subsequent application is optimized, and a reading time of the data is reduced.
6. Filtering is performed based on a parameter and a name of the component, under a rule specified by the user. In case of a data rule being feasible, the filtering is performed by using an optimization method, such as a quick sorting method. A time cost of the retrieval is reduced.

Further in this embodiment, the data cache and the retrieval rule may be converted into data streams and stored as files on user's requirement, so as to optimize subsequent retrieval. The data cache is cleared when not necessary, to reduce a pressure on memory. In embodiments of the present disclosure, all rules and conditions may be stored in the database.

In summary, the method according to embodiments of the present disclosure is a component retrieval method based on an abstract data type in the software Revit. Through hierarchical and progressive retrieval, a required component is retrieved sequentially at a level of a big-project BIM model file (version and domain), at a level of a category of the component (component category determination), and finally at a level of the attribute information of the component (component attribute definition). Thereby, a quick retrieval mode is formed, and a component can be quickly retrieved from mass information in a list of a big-project file. Efficiency of such process is improved by reducing a time cost of conventional retrieval from a few minutes to a few seconds. A function of model checking is spared, improving the efficiency.

Sequence of the above embodiments in the present disclosure is merely for facilitating description, and does not represent preference among the embodiments.

As described above, the above embodiments are only intended to describe the technical solutions of the present disclosure, and not to limit the present disclosure. Although the present disclosure is described in detail with reference to the above embodiments, those skilled in the art should understand that, modifications can be made to the technical solutions recorded in the above embodiments, or equivalent replacements can be made to some of the technical features thereof, and the modifications and the replacements will not make the corresponding technical solutions deviate from the spirit and the scope of the technical solutions of the embodiments of the present disclosure.

## Claims

1. A method for quickly retrieving component information from a BIM model, comprising:
reading a BIM model file to obtain component information in the BIM model file, and establishing a list of rules for preliminary component retrieval;
determining a category of a component in the component list according to a rule in a database, to obtain category information of the component;
determining an attribute of the component in the component list according to a rule for attribute definition in the database, to obtain attribute information of the component;
optimizing the list of rules for preliminary component retrieval, based on the category information of the component and the attribute information of the component that are obtained;
establishing a retrieval order and obtaining a comparison filter rule, based on a weight of a retrieval type that is set and the optimized list of rules for preliminary component retrieval;
performing preliminary retrieval according to the obtained comparison filter rule, to obtain a preliminary retrieval result, and optimizing the preliminary retrieval result; and
filtering the preliminary retrieval result, according to a rule set in the database and the category and the attribute of the component that are obtained, to obtain a component retrieval result, and storing the component retrieval result.

2. The method for quickly retrieving component information from a BIM model according to claim 1, wherein the preliminary retrieval is performed by using binary search.

3. The method for quickly retrieving component information from a BIM model according to claim 1, further comprising:
filtering a type of virtual data in software Revit, and/or
modifying a type of virtual data in software Revit by comparison.
